# EUROPEAN PATENT APPLICATION

(11) **EP 1 174 763 A2**
(43) Date of publication of application: **23.01.2002**
(21) Application number: 01116405.0
(22) Date of filing: 06.07.2001
(51) Int. Cl.: G03F 1/08, H01L 21/027

(54) **Method of fabricating a nickel etching mask**

(30) Priority: 18.07.2000 KR 2000040909
(71) Applicant: SAMSUNG ELECTRONICS CO., LTD., Suwon-City, Kyungki-do (KR)
(72) Inventor: Jung, Sun-Tae, Suwon-city, Kyungki-do (KR); Choi, Duk-Yong, Suwon-city, Kyungki-do (KR); Lee, Joo-Hoon, Suwon-city, Kyungki-do (KR)
(74) Representative: Grünecker, Kinkeldey, Stockmair & Schwanhäusser Anwaltssozietät

(57) **Abstract**

There is provided a metal etching mask fabrication method. Chrome is first sputtered on a silica layer and a photoresist is deposited to be thick on the chrome layer. The photoresist layer is patterned, first nickel is sputtered on the photoresist pattern layer, and a second nickel layer is formed on the first nickel layer by plating. The photoresist pattern layer and the first nickel layer formed on the photoresist pattern layer are removed using acetone, and the chrome layer is removed by dry etching in plasma using a gas.

## Description

### BACKGROUND OF THE INVENTION

### 1. Field of the Invention

The present invention relates generally to a light waveguide fabrication method, and in particular, to a method of fabricating a nickel etching mask by plating for manufacture of a silica PLC (Planar Lightwave Circuit).

### 2. Description of the Related Art

Many studies have recently been made on optical devices integration technology of fabricating light waveguides on a planar substrate by PLC techniques for the purpose of optical signal processing including division, modulation, switching, and multiplexing of optical signals. The production of light waveguides device involves designing, manufacture, and packaging of the light waveguides. A light waveguide is an optical transmission line keeping light waves and propagating them with low loss along the length direction. The light waveguide is comprised of a core with a high refractive index and a cladding with a low refractive index surrounding the core. Light waveguide applications on a planar silicon substrate include AWGs (Arrayed Waveguide Gratings) and thermal optical switches. These optical devices are fabricated by forming optical signal propagation paths through patterning on a plan, in particular a planar substrate. A metal mask is usually used to fabricate a PLC for an optical communication module. The metal mask is formed by sputtering of a metal layer, photoresist patterning, and dry etching.

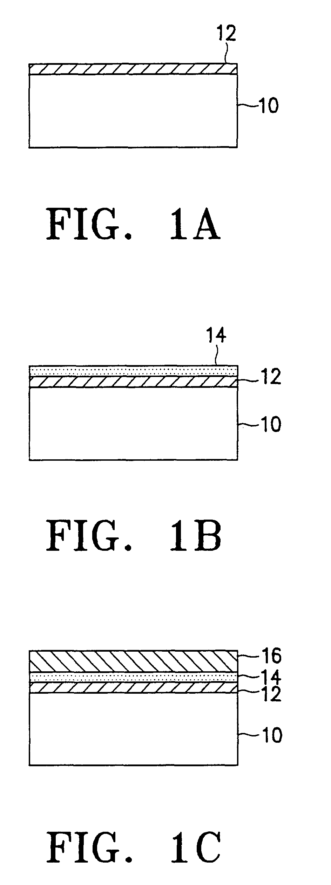

FIGs. 1A to 1G are sectional views sequentially illustrating a conventional metal etching mask fabrication method for use in manufacture of a PLC.

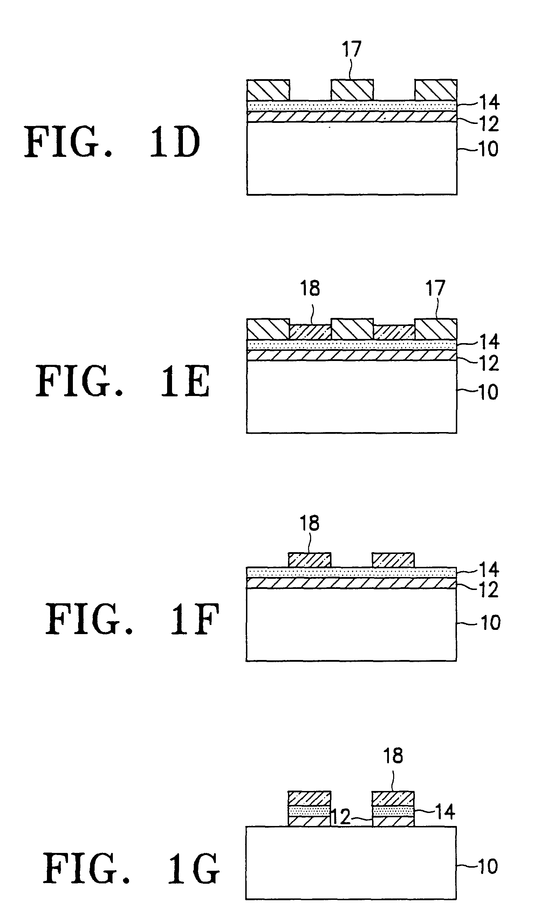

FIG. 1A illustrates the step of depositing chrome on a silica layer 10, formed by depositing silica (SiO₂) on silicon (Si), by sputtering. A chrome seed layer 12 is formed to a thickness of tens of nanometers on a substrate 10. FIG. 1B illustrates the step of depositing gold on the chrome seed layer 12 by sputtering. The thickness of a gold seed layer 14 is tens of nanometers. FIG. 1C illustrates the step of forming a photoresist layer 16 to be relatively thick on the chrome seed layer 12. FIG. 1D illustrates the step of patterning the photoresist layer 16 by photolithography. FIG. 1E illustrates the step of forming a nickel layer 18 by plating nickel on photoresist patterns 17. The nickel layer 18 grows selectively only on conductive portions. FIG. 1F illustrates the step of removing the photoresist patterns 17 using acetone. FIG. 1G illustrates the step of removing the gold seed layer 14 by wet etching and the chrome seed layer 12 by dry etching.

The nickel layer 18 shows a bad junction with the substrate 10. Therefore, it is difficult to use the nickel layer as a seed layer. Instead, a chrome layer showing a good junction with the substrate is used as a seed layer.

However, when nickel is plated on the chrome seed layer 12, the bad junction between the surfaces of the nickel and the chrome seed layer 12 separates them. To solve this problem, the gold layer 14 having a good junction with both chrome and nickel is interposed between the nickel layer and the chrome layer. The use of the different seed layers (i.e., the chrome layer and the gold layer) causes process complexity, that is, separate implementation of dry etching and wet etching in the conventional etching mask fabrication method.

Deposition of the two seed layers and particularly, different removal processing of the seed layers after plating results in process complexity and increased processing time. The gold layer may change the line width of a waveguide and require cleansing since it is isotropically etched by wet etching. Furthermore, the Bull's eye effect during dry etching changes the line widths of patterns across a substrate.

### SUMMARY OF THE INVENTION

It is, therefore, an object of the present invention to provide a method of fabricating an etching mask with nickel plated on a chrome seed layer and a nickel seed layer.

It is another object of the present invention to provide a nickel etching mask fabrication method for simplifying processing.

It is a further object of the present invention to provide a nickel etching mask fabrication method for minimizing the possibility of contamination.

The foregoing and other objects can be achieved by providing a metal etching mask fabrication method. Chrome is first sputtered on a silica layer and a photoresist is deposited to be thick on the chrome layer. The photoresist layer is patterned, first nickel is sputtered on the photoresist pattern layer, and a second nickel layer is formed on the first nickel layer by plating. The photoresist pattern layer and the first nickel layer formed on the photoresist pattern layer are removed using acetone, and the chrome layer is removed by dry etching in plasma using a gas.

### BRIEF DESCRIPTION OF THE DRAWINGS

The above and other objects, features and advantages of the present invention will become more apparent from the following detailed description when taken in conjunction with the accompanying drawings in which:
FIGs. 1A to 1G are sectional views sequentially illustrating a conventional etching mask fabrication method; and
FIGs. 2A to 2G are sectional views sequentially illustrating a nickel etching mask fabrication method according to an embodiment of the present invention.

### DETAILED DESCRIPTION OF THE PREFERRED EMBODIMENT

A preferred embodiment of the present invention will be described hereinbelow with reference to the accompanying drawings. In the following description, well-known functions or constructions are not described in detail since they would obscure the invention in unnecessary detail.

Plating of nickel is mainly applied to MEMS (MicroElectro-Mechanical System). Anna Massimi, et al introduced this technique to etching of light waveguides. The nickel-plating technique advantageously facilitates fabrication of a relatively thick metal mask and removes the Bull's eye effect generated during dry etching. In accordance with the present invention, a second nickel layer is formed on a chrome seed layer and a first nickel seed layer by plating nickel and the first nickel seed layer is deposited after photoresist patterning to remove the chrome seed layer and the first nickel seed layer at one step.

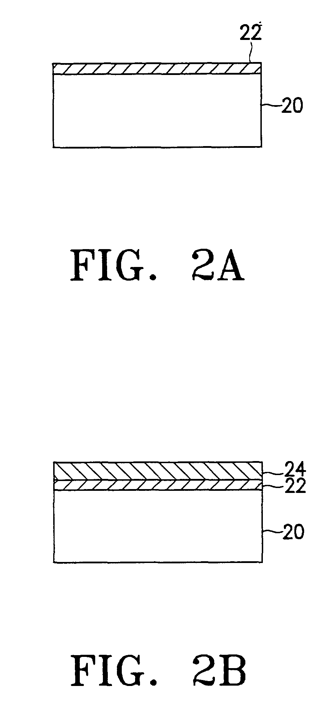

An etching mask fabricating method according to the present invention will be described referring to FIGs. 2A to 2G.

Referring to FIG. 2A, a silica layer 20 is deposited on a planar substrate, particularly a planar silicon substrate and a chrome seed layer 22 is uniformly deposited on the silica layer 20 to a thickness ranging from tens of nanometers to 100nm.

Referring to FIG. 2B, a photoresist layer 24 is formed on the chrome seed layer 22 to thicker than the chrome seed layer 22.

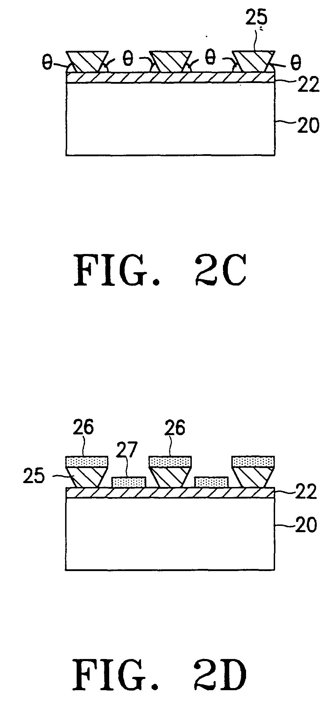

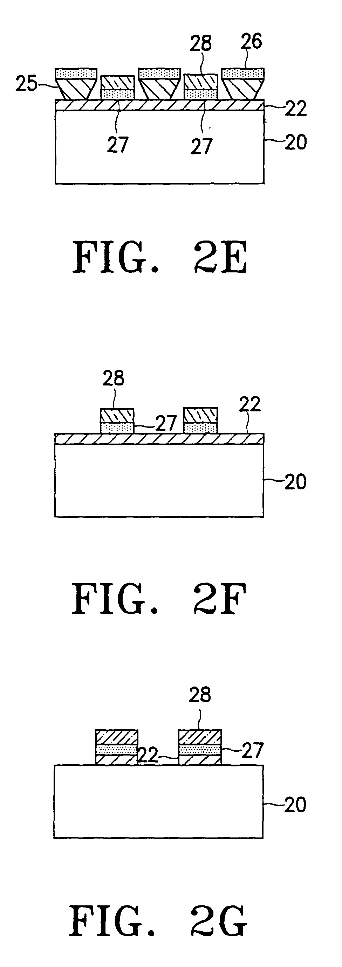

Referring to FIG. 2C, a photoresist pattern layer 25 is formed by soft-baking the photoresist layer 24 and immersing it in a chlorobenzene solution. Here, the side angles of the photoresist pattern layer 25 with the chrome seed layer 22 must be obtuse. If the angles are acute, a layer deposited on the photoresist pattern layer 25 may be electrically connected to a first nickel seed layer 27 deposited on the chrome seed layer 22 when a first nickel seed layer 26 is deposited (see FIG. 2D). This will make it difficult to remove the photoresist pattern layer 25 because nickel is also plated on the photoresist pattern layer 25 in a nickel-plating step (see FIG. 2E).

Referring to FIG. 2D, the first nickel seed layer 26 is deposited on the photoresist pattern layer 25 and the first nickel seed layers 27 are deposited to a predetermined width on the chrome seed layer 22 between photoresist patterns by sputtering.

Referring to FIG. 2E, a second nickel layer 28 is deposited only on the first nickel seed layers 27 on the nickel seed layer 22 by plating nickel on the first nickel seed layers 26 and 27 because the surface of the photoresist layer pattern 25 is not conductive and thus resists plating.

Referring to FIG. 2F, the photoresist pattern layer 25 is removed along with the overlying first nickel seed layer 26 using acetone.

Referring to FIG. 2G, the chrome seed layer 22 is dry-etched in plasma at 100 to 500W with 50 to 2000nTorr using a Cl₂+O₂ gas by RIE (Reactive Ion Etching).

Consequently, the photoresist pattern layer 25 and the first nickel seed layer 26 are removed together, thereby reducing the number of processes.

In accordance with the present invention as described above, a relatively thick metal mask is easily fabricated by plating and the Bull's eye effect produced during dry etching is removed. While the conventional plating method has the problem of process complexity due to deposition of two seed layers, the process is simplified and time is saved in fabricating an etching mask according to the present invention. In addition, since wet etching is not performed, cleansing is omitted, thereby reducing the possibility of contamination.

While the invention has been shown and described with reference to a certain preferred embodiment thereof, it will be understood by those skilled in the art that various changes in form and details may be made therein without departing from the spirit and scope of the invention as defined by the appended claims.

## Claims

1. A metal etching mask fabrication method comprising the steps of:
sputtering chrome (22) on a silica layer (20);
depositing a photoresist (24) to be thick on the chrome layer (22);
patterning the photoresist layer (24);
sputtering a first nickel layer (26) on the photoresist pattern layer (25);
forming a second nickel layer (28) on the first nickel layer by plating (26);
removing the photoresist pattern layer (25) and the first nickel layer (26) formed on the photoresist pattern layer (25); and
removing the chrome layer (22).

2. The metal etching mask fabrication method of claim 1, wherein acetone is used for removing the photoresist pattern layer (25) and the first nickel layer (26) formed on the photoresist pattern layer (25).

3. The metal etching mask fabrication method of claim 1 or 2, wherein the chrome layer (22) is removed by dry etching in plasma using a gas.

4. The metal etching mask fabrication method of any of claims 1 to 3, wherein the side angles of the photoresist pattern layer (25) are obtuse.

5. The metal etching mask fabrication method of any of claims 1 to 4, wherein the photoresist pattern layer (25) is formed in immersing the photoresist layer (24) in a chlorobenzene solution.

6. The metal etching mask fabrication method of any of claims 1 to 5, wherein the dry etching of the chrome layer (22) is performed at 100 to 500W.

7. The metal etching mask fabrication method of any of claims 1 to 6, wherein the dry etching of the chrome layer (22) is performed at a pressure of 50 to 200mTorr.

8. The metal etching mask fabrication method of any of claims 1 to 7, wherein the gas used for the dry etching of the chrome layer (22) is Cl₂+O₂.
